# EUROPEAN PATENT APPLICATION

(11) **EP 3 032 166 A1**
(43) Date of publication of application: **15.06.2016**
(21) Application number: 14835423.6
(22) Date of filing: 08.07.2014
(51) Int. Cl.: F21S 8/10, B01D 39/16

(54) **VENTILATION MEMBER**

(30) Priority: 09.08.2013 JP 2013167051
(71) Applicant: Nitto Denko Corporation, Ibaraki-shi, Osaka 567-8680 (JP)
(72) Inventor: ISHII, Kyoko, Ibaraki-shi Osaka 567-8680 (JP); YANO, Youzou, Ibaraki-shi Osaka 567-8680 (JP); FURUUCHI, Kouji, Ibaraki-shi Osaka 567-8680 (JP)
(74) Representative: Intès, Didier Gérard André
(86) International application number: PCT/JP2014/003622
(87) International publication number: WO 2015/019545

(57) **Abstract**

A ventilation member (1A) includes a wall portion (2a), an attachment portion (2b), and a plurality of recessed portions (2d). The wall portion (2a) is formed to define the recessed portions (2d) and is configured to allow a gas to pass through between its inner surface facing the recessed portions (2d) and its outer surface opposite to the inner surface. The attachment portion (2b) is formed to extend outwardly around a rectangular opening (2c) and provides an attachment surface adapted to be attached to a housing (50) that needs to be ventilated. The ventilation member (1A) is a member formed of a porous resin, and at least the wall portion (2a) and the attachment portion (2b) are integrally formed.

## Description

### TECHNICAL FIELD

The present invention relates to a ventilation member used to reduce pressure variation in a housing or to allow replacement of air in the housing.

### BACKGROUND ART

Conventionally, for example, in automobile electric components such as automobile lamps and ECUs (Electrical Control Units), OA (office automation) equipment, household electric appliances, and medical devices, a housing containing an electric component or a control board is provided with an opening for the purpose of reducing pressure variation in the housing caused by temperature change or allowing replacement of air in the housing, and a ventilation member is attached to the opening. The ventilation member ensures ventilation between the inside and outside of the housing, and also prevents foreign matters such as dust and water from entering the housing. An example of such a ventilation member is disclosed in Patent Literature 1.

Patent Literature 1 discloses a ventilation member 101 as shown in FIG. 10 to FIG. 12. The ventilation member 101 includes a gas-permeable membrane 102 and a support body 103. The support body 103 has a through hole 103c, a first angled protruding portion 103a, and a second angled protruding portion 103b. The first and second angled protruding portions 103a and 103b are provided along two opposite edges of the opening of the through hole 103c and have alternate peaks and valleys. A gas-permeable membrane 102 is joined onto the first angled protruding portion 103a and the second angled protruding portion 103b and has a pleated shape with alternate peaks and valleys along the shape of the first angled protruding portion 103a and the second angled protruding portion 103b. In this ventilation member 101, a gas passes through the gas-permeable membrane 102, as a result of which ventilation between a space inside a housing and a space outside the housing can be ensured. Patent Literature 1 discloses a porous polytetrafluoroethylene (PTFE) membrane as the gas-permeable membrane 102. The porous structure of the porous PTFE membrane is formed by stretching and then the resulting porous PTFE membrane is subjected to pleating. Thus, the gas-permeable membrane 102 having a pleated shape as shown in the figures is obtained.

### CITATION LIST

### Patent Literature

Patent Literature 1: JP 2011-233518 A

### SUMMARY OF INVENTION

### Technical Problem

The ventilation member 101 disclosed in Patent Literature 1 is designed to increase the gas-permeable area by pleating the gas-permeable membrane 102. However, the first angled protruding portion 103a and the second angled protruding portion 103b formed in the gas-impermeable support body 103 do not contribute to improving the gas permeability. In addition, in order to prevent leakage of a gas through the joining portion of the gas-permeable membrane 102 and the first and second angled protruding portions 103a and 103b, the pleats of the gas-permeable membrane 102 and the first and second angled protruding portions 103a and 103b are required to have high shape accuracy, and high accuracy is required to join them. Therefore, the ventilation member 101 is not necessarily designed suitably for mass production.

In view of such circumstances, the present invention aims to provide a ventilation member suitable for improvement of gas permeability and mass production.

### Solution to Problem

The present invention provides a ventilation member formed of a porous resin. The ventilation member includes:
at least one recessed portion having an opening;
a wall portion formed to define the recessed portion and having an inner surface facing the recessed portion and an outer surface opposite to the inner surface, the wall portion being configured to allow a gas to pass through between the inner surface and the outer surface; and
an attachment portion formed integrally with the wall portion to extend outwardly around the opening of the recessed portion and adapted to be attached to a housing that needs to be ventilated.

### Advantageous Effects of Invention

According to the ventilation member of the present invention, the entire wall portion formed to define the recessed portion ensures gas permeability. In addition, the attachment portion for attachment to the housing is formed integrally with the wall portion. Therefore, the ventilation member is suitable for improvement of gas permeability and mass production.

### BRIEF DESCRIPTION OF DRAWINGS

FIG. 1 is a perspective view of a ventilation member according to a first embodiment of the present invention.
FIG. 2 is a cross-sectional view of the ventilation member shown in FIG. 1.
FIG. 3 is a perspective underside view of the ventilation member shown in FIG. 1.
FIG. 4 is a perspective view of a ventilation member according to a second embodiment of the present invention.
FIG. 5 is a cross-sectional view of the ventilation member shown in FIG. 4.
FIG. 6 is a perspective underside view of the ventilation member shown in FIG. 4.
FIG. 7 is a perspective view of a ventilation member according to a third embodiment of the present invention.
FIG. 8 is a cross-sectional view of the ventilation member shown in FIG. 7.
FIG. 9 is a perspective underside view of the ventilation member shown in FIG. 7.

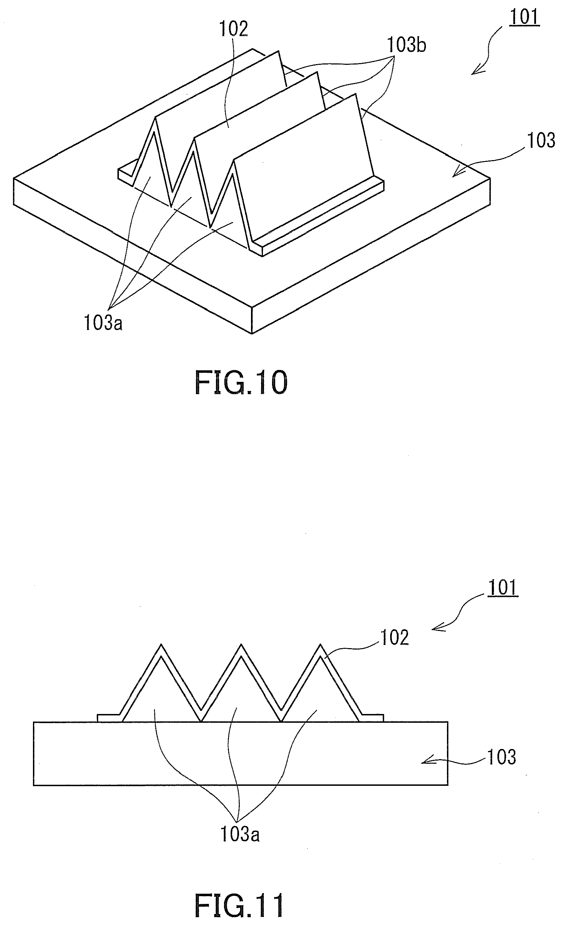

FIG. 10 is a perspective view of a conventional ventilation member.
FIG. 11 is a side view of the ventilation member shown in FIG. 10.

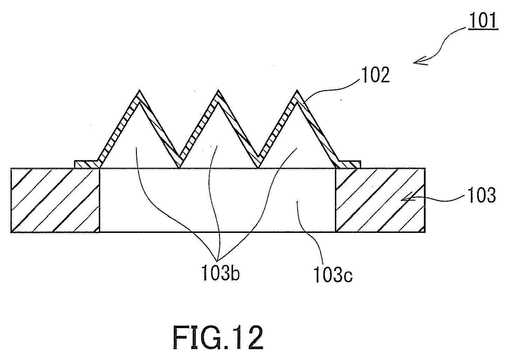

FIG. 12 is a cross-sectional view of the ventilation member shown in FIG. 10.

### DESCRIPTION OF EMBODIMENTS

Hereinafter, embodiments of the present invention will be described with reference to the accompanying drawings. The following description relates to illustrative examples of the present invention, and these examples are not intended to limit the present invention. Hereinafter, the same components as those described previously are designated by the same reference numerals, and the description thereof is omitted in some cases.

### (First Embodiment)

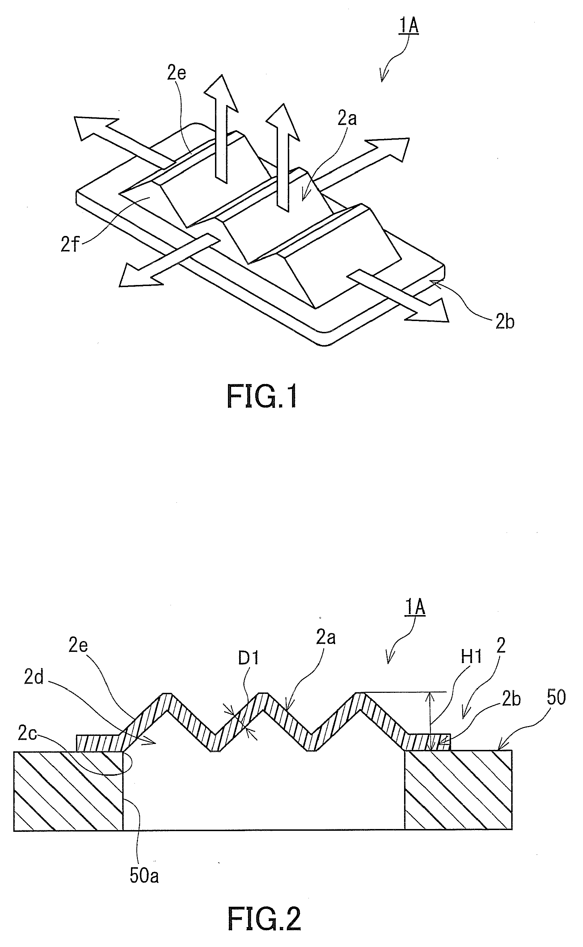

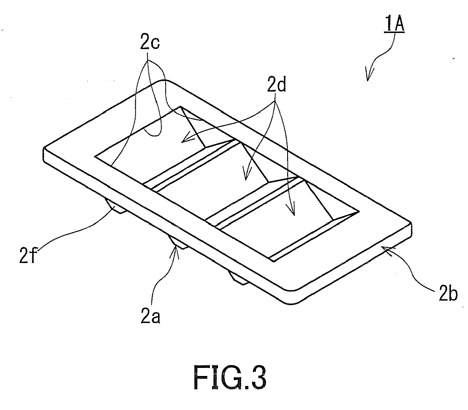

FIG. 1 to FIG. 3 each show a ventilation member 1A according to the first embodiment of the present invention. The ventilation member 1A includes a wall portion 2a, an attachment portion 2b, and a plurality of (specifically, three) recessed portions 2d. These recessed portions 2d have one common opening 2c and are recessed from the opening 2c in the same direction. The wall portion 2a is formed to define the recessed portions 2d and allows a gas to pass through between its inner surface facing the recessed portions 2d and its outer surface opposite to the inner surface. The attachment portion 2b is formed to extend outwardly around the rectangular opening 2c and provides an attachment surface adapted to be attached to a housing 50 that needs to be ventilated. The ventilation member 1A is formed of a porous resin, and at least the wall portion 2a and the attachment portion 2b are integrally formed. The wall portion 2a and the attachment portion 2b are not members that are separately formed and joined together but they are each a part of the ventilation member 1A as a single member formed of a porous resin.

The wall portion 2a has an inclined portion 2e having a ridged cross section and ridged portions 2f closing both sides of the inclined portion 2e. In the present embodiment, the inclined portion 2e has a pleated shape with flattened ridges and includes three projecting portions. The ridged portions 2f cover both sides of the respective projecting portions and thus include six projection sides. The shape (for example, the inclination angle of the inclined surface of the projecting portion or that of the inclined side of the projection side) of the inclined portion 2e and the ridged portion 2f and the number of the inclined portions 2e and the ridged portions 2f are not particularly limited. The inclined portion 2e and the ridged portions 2f are integrally formed of a porous resin and constitute the wall portion 2a.

The attachment portion 2b is usually fixed to the outer surface of the housing 50 with a fastener such as an adhesive tape or an adhesive agent. The attachment portion 2b may be fixed directly to the outer surface of the housing 50 by welding or the like. In the present embodiment, the opening portion 50a of the housing 50 has a rectangular shape, and the opening 2c also has the same rectangular shape as the opening portion 50a so that the opening portion 50a and the opening 2c are aligned with each other. The opening 2c is located at a position where the opening 2c and the opening portion 50a of the housing 50 communicate with each other. Since the attachment portion 2b is also formed of a porous resin like the wall portion 2a, the attachment portion 2b itself can serve as a gas passage. However, since the inner surface of the attachment portion 2b is fixed to the wall portion of the gas-impermeable housing 50, the gas permeability of the ventilation member 1A is substantially ensured by the wall portion 2a.

The porous resin forming the ventilation member 1A is a porous molded body composed of resin fine particles that are bound together. Preferably, the porous resin molded body has a porosity of 20 to 90%. The resin is not particularly limited, and it is preferably ultra-high molecular weight polyethylene. As used herein, the term "ultra-high molecular weight polyethylene" refers to a polyethylene having an average molecular weight of 500,000 or more. The average molecular weight of ultra-high molecular weight polyethylene is generally in the range of 2,000,000 to 10,000,000. The average molecular weight can be measured, for example, by a method according to ASTM D 4020 (viscosity test). Hereinafter, ultra-high molecular weight polyethylene is abbreviated to "UHMWPE".

The porous UHMWPE resin molded body can be produced from a sintered body of UHMWPE powder. The sintered body of UHMWPE powder can be obtained by sintering UHMWPE powder (for example, an UHMWPE powder with an average particle diameter of 30 to 200 µm) placed in a mold at a temperature close to the melting point of UHMWPE (for example, a temperature of 130 to 160°C). The ventilation member 1A formed of the porous UHMWPE resin molded body is obtained by using a mold of a desired shape for a sintered body or by cutting a sintered body block thus obtained into a desired shape. According to this production method (powder sintering method), the resulting porous UHMWPE resin molded body has a porosity in the range of 20 to 90%.

The surface of the ventilation member 1A may be subjected to liquid-repellent treatment. The liquid-repellent treatment can be carried out by a commonly-known method. The liquid-repellent agent used for the liquid-repellent treatment is not particularly limited, and it is typically a material containing a polymer having a perfluoroalkyl group. Examples of the method for forming a coating film containing a polymer having a perfluoroalkyl group include: coating methods in which coating with a solution or a dispersion of a polymer having a perfluoroalkyl group is performed by air spraying, electrostatic spraying, dip coating, spin coating, roll coating (including kiss coating and gravure coating), curtain flow coating, impregnation, or the like; and coating film forming methods using electrodeposition coating or plasma polymerization. In the present embodiment, for example, in impregnation, a liquid-repellent agent that comprises a polymer containing a monomer component represented by the general formula C₄F₉(CH₂CF₂)(CF₂CF₂)₂CH₂CH₂OCOCH = CH₂ can be used.

In order to achieve both high strength and high gas permeability of the ventilation member 1A, the thickness D1 of the ventilation member 1A (i.e., the thickness of the wall portion 2a) is desirably 0.2 mm or more and 20 mm or less, preferably 0.3 mm or more and 10 mm or less, more preferably 0.5 mm or more and 10 mm or less, even more preferably 1 mm or more and 5 mm or less, and particularly preferably 1.5 mm or more and 5 mm or less. The attachment portion 2b may have the same thickness as the wall portion 2a, or the attachment portion 2b may be designed to have a thickness slightly greater than the wall portion 2b. The height H1 of the ventilation member 1A (i.e., the height from the outer surface of the housing 50) is desirably 5 mm or more and 50 mm or less, and preferably 10 mm or more-and 30 mm or less.

### (Second Embodiment)

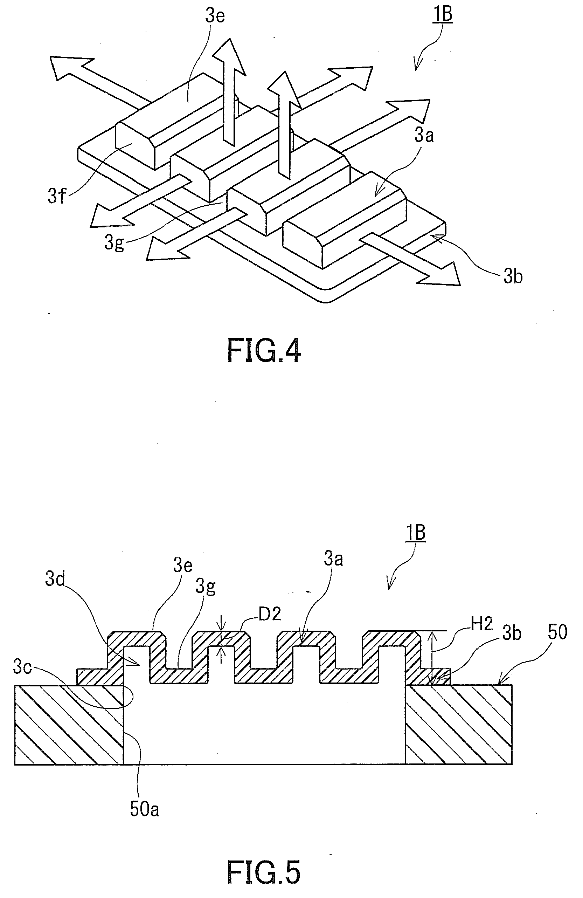

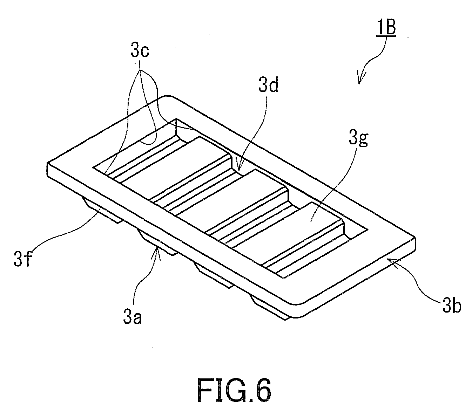

Next, a ventilation member 1B according to the second embodiment of the present invention will be described with reference to FIG. 4 to FIG. 6.

The ventilation member 1B includes a wall portion 3a, an attachment portion 3b, and a plurality of (specifically, four) recessed portions 3d. The wall portion 3a is formed to define the recessed portions 3d and allows a gas to pass through between its inner surface facing the recessed portions 3d and its outer surface opposite to the inner surface. These recessed portions 3d have one common opening 3c and are recessed from the opening 3c in the same direction. The attachment portion 3b is formed to extend outwardly around the rectangular opening 3c and provides an attachment surface adapted to be attached to a housing 50 that needs to be ventilated. The ventilation member 1B is formed of a porous resin, and at least the wall portion 3a and the attachment portion 3b are integrally formed. The wall portion 3a and the attachment portion 3b are not members that are separately formed and joined together but they are each a part of the ventilation member 1B as a single member formed of a porous resin.

The wall portion 3a has bottom wall portions 3e defining the bottom surfaces of the respective recessed portions 3d and side wall portions 3f defining the peripheral surfaces of the respective recessed portions 3d. In the present embodiment, the wall portion 3a includes four separate projecting portions, and the projecting portions each have the bottom wall portion 3e and the side wall portion 3f. The four projecting portions are connected by connecting portions 3g. The outer surfaces of the connecting portions 3g facing outside the housing 50 are smoothly connected to the surface of the attachment portion 3b. The shape and number of the bottom wall portions 3e and those of the side wall portions 3f are not particularly limited. For example, the outline of the bottom wall portion 3e need not be rectangular but may be circular so that the side wall portion 3f has a cylindrical shape. The bottom wall portions 3e, the side wall portions 3f, and the connecting portions 3g are integrally formed of a porous resin and constitute the wall portion 3a. Each of the bottom wall portions 3e, the side wall portions 3f, and the connecting portions 3g allows a gas to pass through between its inner surface and its outer surface opposite to the inner surface.

Since the attachment portion 3b is the same as the attachment portion 2b, the description thereof is omitted. In the case where the opening 3c is divided into two or more openings (for example, each recessed portion 3d has an opening 3c) in an embodiment different from that shown in the figures, the attachment portion 3b is formed around a region including all the recessed portions 3d.

The porous resin forming the ventilation member 1B is a porous molded body composed of resin fine particles that are bound together. The resin is not particularly limited, and it is preferably ultra-high molecular weight polyethylene. The surface of the ventilation member 1B may be subjected to liquid-repellent treatment.

As shown in FIG. 5, the preferred range of the thickness D2 of the ventilation member 1B (i.e., the thickness of the bottom wall portions 3e) is the same as that of the thickness D1, and the preferred range of the height H2 of the ventilation member 1B is the same as that of the height H1.

### (Third Embodiment)

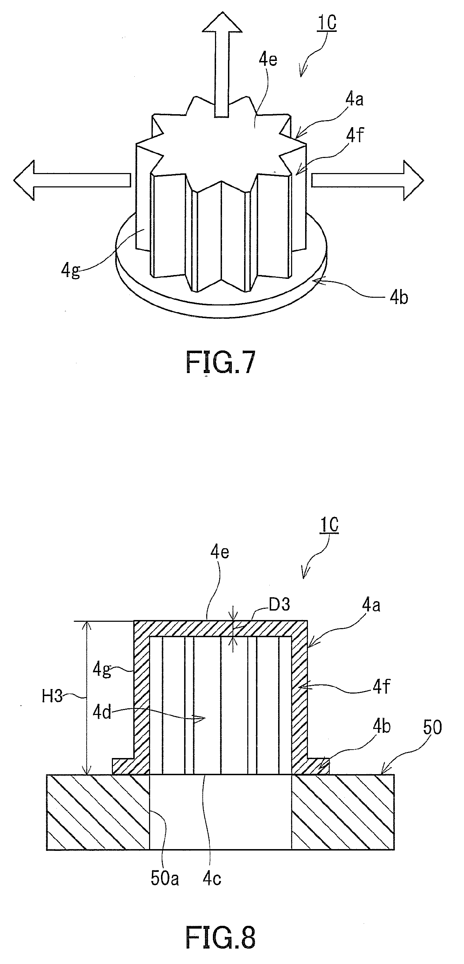

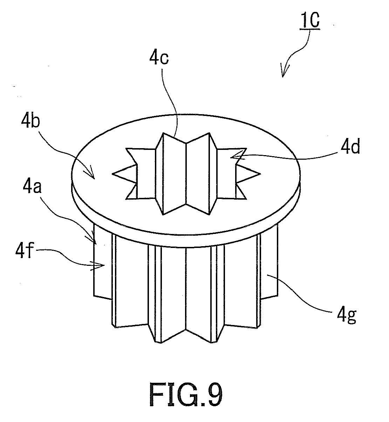

Next, a ventilation member 1C according to the third embodiment of the present invention will be described with reference to FIG. 7 to FIG. 9.

The ventilation member 1C includes a wall portion 4a, an attachment portion 4b, and a recessed portion 4d having an opening 4c. The wall portion 4a is formed to define the recessed portion 4d and allows a gas to pass through between its inner surface facing the recessed portion 4d and its outer surface opposite to the inner surface. The attachment portion 4b is formed to extend outwardly around the opening 4c and provides an attachment surface adapted to be attached to a housing 50 that needs to be ventilated. In the embodiment shown in the figures, the ventilation member 1C has one recessed portion 4d. However, the ventilation member 1C may have a plurality of recessed portions (i.e., a plurality of projecting portions as seen from the underside), and the attachment portion 4b may be formed around a region including these recessed portions. The ventilation member 1C is formed of a porous resin, and at least the wall portion 4a and the attachment portion 4b are integrally formed.

The wall portion 4a has a bottom wall portion 4e defining the bottom surface of the recessed portion 4d and a side wall portion 4f defining the peripheral surface of the recessed portion 4d. The side wall portion 4f has a pleated structure 4g with alternate ridges and valleys. With this pleated structure 4g, the surface area of the side wall portion 4f is increased compared to a configuration without the pleated structure 4g. In the embodiment shown in the figures, the surface of the pleated structure 4g is composed of flat surfaces but may be composed of curved surfaces.

Since the attachment portion 4b is the same as the attachment portion 2b, the description thereof is omitted.

The porous resin forming the ventilation member 1C is a porous molded body composed of resin fine particles that are bound together. The resin is not particularly limited, and it is preferably ultra-high molecular weight polyethylene. The surface of the ventilation member 1C may be subjected to liquid-repellent treatment.

As shown in FIG. 8, the preferred range of the thickness D3 of the ventilation member 1C (i.e., the thickness of the bottom wall portion 4e) is the same as that of the thickness D1. The height H3 of the ventilation member 1C (i.e., the height from the outer surface of the housing 50) is desirably 5 mm or more and 50 mm or less, and preferably 10 mm or more and 30 mm or less.

### INDUSTRIAL APPLICABILITY

The waterproof ventilation member according to the present invention can be applied also to housings other than housings of automobile electric components. For example, the present invention can be applied also to housings of OA equipment, household electric appliances, and medical devices.

## Claims

1. A ventilation member formed of a porous resin, the ventilation member comprising:
at least one recessed portion having an opening;
a wall portion formed to define the recessed portion and having an inner surface facing the recessed portion and an outer surface opposite to the inner surface, the wall portion being configured to allow a gas to pass through between the inner surface and the outer surface; and
an attachment portion formed integrally with the wall portion to extend outwardly around the opening of the recessed portion and adapted to be attached to a housing that needs to be ventilated.

2. The ventilation member according to claim 1, wherein the wall portion comprises: an inclined portion having a ridged cross section; and ridged portions closing both sides of the inclined portion.

3. The ventilation member according to claim 1, wherein the wall portion comprises: a side wall portion defining a peripheral surface of the recessed portion; and a bottom wall portion defining a bottom surface of the recessed portion.

4. The ventilation member according to claim 3, wherein the side wall portion has a pleated structure for increasing a surface area of the side wall portion.

5. The ventilation member according to claim 1, comprising the recessed portions.

6. The ventilation member according to claim 1, wherein a surface of the ventilation member is subjected to liquid-repellent treatment.

7. The ventilation member according to claim 1, wherein the porous resin is a porous molded body composed of resin fine particles that are bound together.

8. The ventilation member according to claim 1, wherein the ventilation member has a thickness of 0.2 mm or more and 20 mm or less.

9. The ventilation member according to claim 1, wherein the porous resin has a porosity of 20% or more and 90% or less.
